# EUROPÄISCHE PATENTANMELDUNG

(11) **EP 1 273 358 A2**
(43) Veröffentlichungstag der Anmeldung: **08.01.2003**
(21) Anmeldenummer: 02022695.7
(22) Anmeldetag: 21.03.2000
(51) Int. Cl.: B05D 7/24, C23C 14/12, C23C 14/56

(54) **Release-Schicht, Verfahren zu ihrer Herstellung sowie Verwendung**

(30) Priorität: 15.04.1999 DE 19917075; 15.07.1999 DE 19933230
(62) Teilanmeldung aus: 00916985.5
(71) Anmelder: Fraunhofer-Gesellschaft zur Förderung der angewandten Forschung e.V., 80636 München (DE)
(72) Erfinder: Moosheimer, Ulrich, 85411 Hohenkammer (DE)
(74) Vertreter: Pfenning, Meinig & Partner GbR

(57) **Zusammenfassung**

Die vorliegende Erfindung bezieht sich auf eine Release-Schicht, ein Verfahren zu ihrer Herstellung sowie Verwendung dieser Release-Schicht. Derartige Release-Schichten werden beispielsweise bei der Herstellung von Pigmenten und bei der Herstellung von Prägefolien eingesetzt.

Erfindungsgemäß besteht die aufgedampfte Release-Schicht aus einem organischen Monomer, vorteilhafterweise aus einem Triazin wie Melamin. Der Auftrag der Release-Schicht und der ablösbaren Deckschicht erfolgt dabei in derselben Bedampfungsanlage. Auch das Ablösen der Release-Schicht erfolgt dabei im Vakuum.

Als Substrat können flächige oder dreidimensionale Materialien dienen, wobei die Release-Schicht zur Erzeugung eines strukturierten Substrates als Endprodukt auch strukturiert aufgedampft werden kann.

Die Release-Schicht kann lackiert, beschichtet oder kaschiert werden.

## Beschreibung

Die vorliegende Erfindung bezieht sich auf eine Release-Schicht, ein Verfahren zu ihrer Herstellung sowie auf Verwendungen derartiger Release-Schichten.

Release-Schichten werden zum Ablösen einer darauf aufgebrachten Schicht verwendet. Das Endprodukt stellt die abgelöste Schicht oder die partiell abgelöste Substratfolie dar. Zum Beispiel wird die abgelöste Schicht zur Herstellung von Pigmenten oder Prägedrucken verwendet. Eine partielle Abdeckung des Substrates vor der Beschichtung mit der Release-Schicht strukturiert nach dem Ablösen der Abdeckung eine zusätzlich aufgebrachte Schicht.

Bei der Herstellung von Pigmenten, z.B. Metalleffektpigmenten auf Basis von Metallen für Lackierungen, wird auf eine lackierte Polymerfolie, z.B. Polyethylenterephthalat (PET), eine einige 10 Nanometer dicke Schicht, z.B. Aluminium, vakuumtechnisch aufgedampft. Bei Eintauchen dieser beschichteten Folie in Lösungsmittel, für Aluminium z.B. Aceton, löst sich die (Aluminium-) Schicht von der Polymerfolie. Aus der gelösten Schicht werden anschließend metallische Pigmente hergestellt. Um größere Pigmente zu erhalten, wird die Aluminiumschicht zusätzlich beschichtet. Ein derartiges Verfahren ist beispielsweise in der US 3 949 139 offenbart.

Nach dem Stand der Technik wird die Polymerfolie zur Herstellung der Pigmente außerhalb des Vakuums lakkiert.

Bei Prägefolien erfolgt nach dem Stand der Technik die Ablösung der zweiten Schicht mittels eines erhitzten Prägestempels.

Aufgabe der vorliegenden Erfindung ist es, Release-Schichten, Verfahren zu ihrer Herstellung sowie Verwendungen derartiger Release-Schichten zur Verfügung zu stellen, die einfach und kostengünstig aufgebracht und abgelöst werden können.

Diese Aufgabe wird durch die Release-Schicht nach dem Oberbegriff des Anspruchs 1, das Verfahren zu ihrer Herstellung nach dem Oberbegriff des Anspruchs 8 in Verbindung mit ihren kennzeichnenden Merkmalen sowie durch die Verwendung nach Anspruch 7 gelöst.

Die vakuumtechnisch aufgedampfte Release-Schicht nach dieser Erfindung enthält ein organisches Monomer. Dadurch wird die Herstellung von Release-Schichten mit Hilfe vakuumtechnischer Beschichtungen auch beispielsweise bei niedrigen Temperaturen möglich. Als organisches Monomer wird vorteilhafterweise ein wasserlösliches organisches Monomer verwendet. Dadurch kann die Verwendung umweltschädlicher Lösungsmittel vermieden werden. Weiterhin wird durch Wasser das Substrat nicht geschädigt, so daß ein geringerer Materialverbrauch und damit geringere Produktionskosten resultieren. Bei vernachlässigbarer Schädigung des Substrates, beispielsweise einer Polymerfolie, durch den gesamten Prozeß kann dieses erneut und sogar mehrfach verwendet werden, so daß sowohl die Umweltbelastung als auch die Prozeßkosten verringert werden.

Die Release-Schicht nach dieser Erfindung besteht aus einem Triazin, vorteilhafterweise einem 1,3,5-Triazin, dessen Salz oder einer Mischung hiervon. Als Triazine kommen insbesondere Melamin, Ammelin, Ammelid, Cyanursäure, 2-Ureidomelamin, Melam, Melem, Melon oder Melaminsalze wie Melamincyanurat, Melaminphosphat, Dimelaminpyrophosphat oder Melaminpolyphosphat oder funktionalisiertes Melamin wie Hexamethoxymethyl-Melamin oder acrylatfunktionalisiertes Melamin oder einer Mischung aus den obigen Substanzen in Frage. Diese Release-Schichten sind zum Teil wasserlöslich und oft leicht zu entfernen. Vorteilhaft an der Verwendung von Melamin bzw. Melaminderivaten ist insbesondere, daß die Verdampfungstemperatur von Melamin lediglich ca. 200 °C beträgt. Dadurch tritt nur eine geringe thermische Belastung des Substrates sowie der in dem Verdampfer befindlichen Blenden oder Bänder auf. Weiterhin löst sich Melamin in warmem Wasser, so daß nicht nur die Release-Schicht mit heißem Wasser aufgelöst werden kann, sondern auch die Reinigung der zur Herstellung der Release-Schicht verwendeten Vorrichtungen einfach mit heißem Wasser durchgeführt werden kann.

Als Substrat eignen sich insbesondere flächige Materialien, insbesondere bandförmige Materialien wie Folien aus Polymeren, da diese bei der Herstellung der erfindungsgemäßen Release-Schichten nur gering thermisch belastet werden und bei der Ablösung der Release-Schicht lediglich mit Wasser in Kontakt kommen. Als Polymere eignen sich hierfür insbesondere Polyester, Polypropylen, Polyethylen, Polyamid, Polycarbonat oder deren Kombinationen. Als Materialien sind auch Papier, Karton, Metallbänder oder deren Kombinationen geeignet.

Diese erfindungsgemäßen Release-Schichten können insbesondere zur Herstellung von Nanopartikeln, zur Herstellung von Pigmenten, beispielsweise metallischen Effektpigmenten, Pigmenten aus TiO₂, SiOₓ oder anderen Oxiden, für die Lackierung oder zur Herstellung von Prägefolien als auch zur Herstellung strukturiert beschichteter Substrate verwendet werden. In letzterem Falle stellt das Substrat mit der strukturierten Oberfläche das erwünschte Produkt dar.

Bei Verwendung eines vorstrukturierten Substrates erfolgt eine Strukturierung der später abgelösten Partikel, insbesondere Nanopartikel. Somit wird die Struktur der Partikel über die Struktur des Substrates bestimmt.

Die Herstellung der erfindungsgemäßen Release-Schichten erfolgt durch vakuumtechnisches Aufbringen der Release-Schicht auf ein Substrat. Dabei kann das Substrat lediglich teilweise mit der Release-Schicht beschichtet werden, um durch Ablösung der nur teilweise aufgebrachten Release-Schicht eine strukturierte Beschichtung des Substrates mit der Deckschicht zu erzielen. Dabei kann auch das Ablösen der Release-Schicht bereits innerhalb der Vakuumkammer erfolgen, beispielsweise indem die Release-Schicht durch Erhitzten unter Vakuum entfernt wird. Es kann auch ein mehrfacher Schichtaufbau erfolgen, so daß eine unterschiedliche Anzahl von Deckschichten in verschiedenen Bereichen des Substrats anschließend abgelöst werden können. Die weiteren Schichten und Deckschichten müssen nicht notwendigerweise vakuumtechnisch aufgebracht werden. Besonders vorteilhaft ist es jedoch, wenn die weiteren Deckschichten und die Release-Schicht/Release-Schichten in derselben Vakuumkammer aufgedampft werden, beispielsweise durch hintereinander angeordnete Verdampfungsquellen. Dadurch erfolgt die gesamte Substratbeschichtung in lediglich einem Arbeitsgang und es ergeben sich verringerte Herstellungskosten.

Die weiteren Deckschichten müssen selbstverständlich nicht notwendigerweise organische Monomere enthalten sondern können auch wie im Stand der Technik anorganische Schichten, wie beispielsweise Aluminium-Schichten oder Oxidschichten sein. Die Release-Schicht kann auch durch, gegebenenfalls mehrfaches, Lackieren, Beschichten oder Kaschieren mit der Deckschicht versehen werden. Die Beschichtung kann in einer weiteren Vakuumanlage erfolgen.

Als Verfahren zur vakuumtechnischen Aufbringung der Release-Schicht/Release-Schichten beziehungsweise der Deckschicht/Deckschichten stehen neben weiteren Verfahren insbesondere thermisches Verdampfen, Kathodenzerstäubung oder chemische Gasphasenabscheidung (CVD) zur Verfügung. Dabei kann das Substrat vor dem Aufdampfen jeder einzelnen Schicht mit einer Plasmaquelle vorbehandelt werden, um die Anhaftung der aufzutragenden Schicht auf der zuvor aufgetragenen Schicht zu verbessern.

Im folgenden werden Beispiele der erfindungsgemäßen Release-Schicht sowie Beispiele vom Verfahren zu ihrer Herstellung beschrieben.

Es zeigen
Figur 1 den prinzipiellen Aufbau einer herkömmlichen Vakuum-Bandbedampfungsanlage und
Figur 2 den prinzipiellen Aufbau einer Vakuum-Bedampfungsanlage für das erfindungsgemäße Verfahren;
Figur 3 den prinzipiellen Aufbau einer weiteren Vakuum-Bedampfungsanlage für das erfindungsgemäße Verfahren;
Figur 4 den prinzipiellen Aufbau einer weiteren Vakuum-Bedampfungsanlage für das erfindungsgemäße Verfahren.

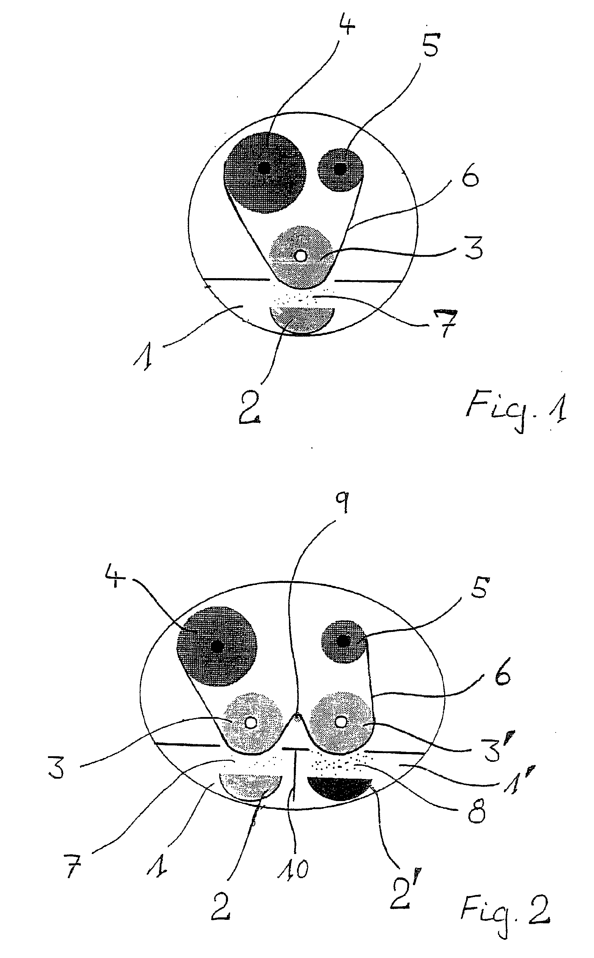

Die Vakuum-Bedampfungsanlage nach dem Stand der Technik, wie sie in Figur 1 gezeigt ist, besitzt eine Beschichtungskammer 1, in der sich ein Verdampfer 2 befindet. Mit diesem Verdampfer 2 wird das Material für eine herkömmliche Release-Schicht in eine Gasphase 7 überführt. Weiterhin weist diese herkömmliche Anlage eine Abwickelrolle 4 und eine Aufwickelrolle 5 für eine Polymerfolie 6 auf. Diese Folie wird über eine Beschichtungswalze 3 geführt, und taucht dadurch in die Gasphase 7 des aufzutragenden Materiales ein. Dadurch wird die Polymerfolie mit der Release-Schicht beschichtet. Anschließend an diese in der Vakuum-Bandbedampfungsanlage erfolgte Beschichtung wird die Folie außerhalb dieser Anlage beispielsweise lackiert.

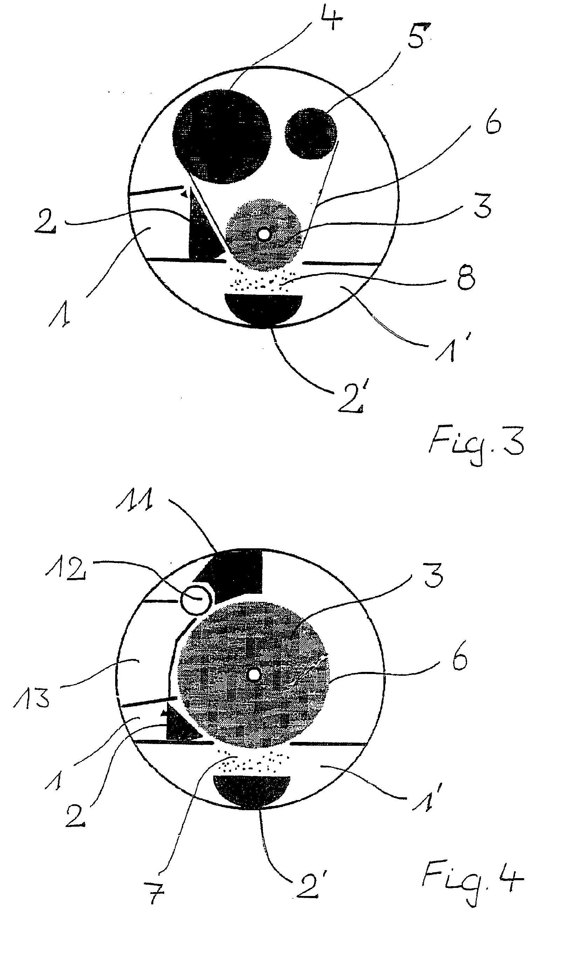

Figur 2 zeigt den Aufbau einer Vakuum-Bandbedampfungsanlage für das erfindungsgemäße Verfahren. Diese Bandbedampfungsanlage weist zwei Beschichtungskammern 1, 1' auf, die voneinander durch eine Zwischenwand 10 getrennt sind. Wie bei der herkömmlichen Bandbedampfungsanlage sind zwei Wickelrollen 4, 5 in der Bandbedampfungsanlage angeordnet, um eine Polymerfolie von der Abwickelrolle 4 auf die Aufwickelrolle 5 zu wickeln. Die Polymerfolie 6 wird dabei über eine Beschichtungswalze 3 eine Umlenkrolle 9 sowie eine Beschichtungswalze 3' geführt.

In den jeweiligen Beschichtungskammern 1, 1' befindet sich jeweils ein Verdampfer 2, 2'. Der Verdampfer 2 verdampft dabei Melamin zur Erzeugung einer Release-Schicht auf dem Polymerband 6. Der Verdampfer 2' enthält Metalle, um auf der Folie 6 eine Pigmentschicht abzulagern. Die Beschichtungswalze 3 ist dabei in der Nähe des Verdampfers 2 und die Be-schichtungswalze 3' des Verdampfers 2' so angeordnet, daß die um diese Beschichtungswalzen geführte Polymerfolie aus Polyethylenterephthalat (PET) in die von den jeweiligen Verdampfern erzeugte Gasphase eintaucht. Zwischen den beiden Beschichtungswalzen 3 und 3' wird die Polymerfolie über eine Umlenkrolle 9 geführt.

In der beschriebenen Vakuum-Bandbedampfungsanlage wird nunmehr die Polymerfolie von der Abwickelwalze 4 über die Beschichtungswalze 3 geführt und dabei mit einer Melaminschicht als Release-Schicht versehen. Über die Umlenkrolle 9 wird die Polymerfolie 6 dann wiederum aus der Melamingasphase herausgeführt und anschließend in die metallische Gasphase, die von dem Verdampfer 2' erzeugt wird, eingebracht. Dort wird die melaminbeschichtete Polymerfolie 6 mit Metallpigmenten beschichtet. Anschließend wird die fertige Polymerfolie auf die Aufwickelwalze 5 aufgewickelt.

Bei dem hier beschriebenen Verfahren tritt aufgrund der niedrigen Verdampfungstemperatur von ca. 250 °C in dem Verdampfer 2 nur eine geringe thermische Belastung der Polymerfolie und der Beschichtungsblenden bzw. Zwischenwände 10 auf. Weiterhin können diese einfach mit heißem Wasser von dem aufgetragenen Melamin gereinigt werden.

Vorteilhaft an der beschichteten Polymerfolie ist, daß die Release-Schicht aus Melamin durch Eintauchen in heißem Wasser aufgelöst werden kann und sich dadurch die zweite aufgedampfte Metallpigmentschicht von der Polymerfolie 6 ablöst.

Figur 3 zeigt eine weitere Beschichtungskammer für das erfindungsgemäße Verfahren, wobei ähnliche Teile mit entsprechenden Bezugszeichen wie in Figur 2 versehen sind. Die Vakuum-Bandbedampfungsanlage in Figur 3 weist wiederum eine Abwickelwalze 4 und eine Aufwickelwalze 5 für eine Folie 6 auf. Diese Folie 6 wird um eine Bedampfungswalze 3 herumgeführt. Seitlich und unterhalb der Bedampfungswalze 3 sind zwei Bedampfungskammern 1, 1' angeordnet mit jeweiligen Verdampfern 2 bzw. 2'. Der Verdampfer 2 ist in dem Bereich angeordnet, in dem die Folie 6 zwischen der Abwickelwalze 4 und der Bedampfungswalze 3 gespannt ist. Durch ihn wird Melamin als Release-Schicht auf die Folie 6 aufgetragen. Mit dem Verdampfer 2', der sich unterhalb der Bedampfungswalze 3 befindet, wird die Folie mit Metallpigmenten beschichtet, bevor sie wieder auf die Aufwickelwalze 5 aufgewickelt wird.

In Figur 4 ist ein anderes Prinzip zur Erzeugung von Metallpigmentpartikeln mittels des erfindungsgemäßen Verfahrens beschrieben. Die Vakuum-Bedampfungsanlage aus Figur 4 ist wiederum bei entsprechenden Teilen mit entsprechenden Bezugszeichen wie in Figur 3 versehen. Sie weist wiederum zwei Bedampfungskammern 1, 1' mit jeweils einem Verdampfer 2, 2' auf, die beide um eine Bedampfungswalze 3 angeordnet sind. Im Gegensatz zu Figur 3 wird hier jedoch ein auf der Bedampfungswalze 3 umlaufendes Metallband oder die Metallwalze selbst von den Bedampfern beschichtet, statt einer um die Bedampfungswalze 3 herumgeführten Folie. In der Beschichtungskammer 1 wird zuerst die Metallwalze 3 bzw. das auf dieser umlaufende Metallband 6 mit Melamin und anschließend in der Bedampfungskammer 1' mit Metallpartikeln, wie beispielsweise Aluminium, beschichtet. Auf dem weiteren Umfang der Bedampfungswalze 3 ist eine Wärmequelle 11 sowie eine Ablösewalze 12 und eine Ablösekammer 13 angeordnet. Ein auf der Bedampfungswalze durch die Verdampfer 2 und 2' mit Melamin und Aluminium beschichteter Bereich der Bedampfungswalze 3 bzw. des umlaufenden Bandes läuft während einer Umdrehung der Bedampfungswalze 3 bzw. des umlaufenden Bandes folglich auch an der Wärmequelle und der Ablösewalze 12 vorbei. Von der Wärmequelle 11 wird die Bedampfungswalze 3 bzw. das umlaufende Band auf ca. 250 °C aufgeheizt. Dadurch verdampft im Bereich der Wärmequelle 11 und der Ablösewalze 12 das Melamin und das oberhalb dieser Melamin-Release-Schicht aufgetragene Aluminium löst sich von der Metallwalze 3 bzw. dem auf dieser umlaufenden Metallband 6. Das Aluminiumpigment wird anschließend in der Ablösekammer 13 gewonnen und aus der Vakuumkammer entfernt. Damit steht der nunmehr melamin- und aluminiumfreie Bereich auf der Metallwalze 3 bzw. dem auf dieser umlaufenden Metallband 6 wiederum zur Bedampfung in den Bedampfungskammern 1 und 1' mit Melamin und Aluminium zur Verfügung. Der Vorteil dieses Verfahrens liegt im kontinuierlichen Betrieb der Anlage, da kein Rollenwechsel von Abwickelrollen 4 und Aufwickelrollen 5 und Rollenmaterial 6 wie bei den Figuren 1 bis 3 beschrieben, notwendig ist.

Weitere Möglichkeiten einer Vorrichtung und eines Verfahrens wie zu Figur 4 beschrieben, bestehen darin, daß die Ablösung der aufgedampften Schichten im Vakuum erfolgen kann, das heißt, beispielsweise die Ablösekammer 13 unter Vakuum steht. Als Ablöseverfahren stehen außer Erhitzen der Walze 3 oder des umlaufenden Bandes an der entsprechenden Stelle auch Verfahren unter Verwendung von Elektronenstrahlen, Laser und/oder Photonenstrahlung bzw. Infrarotstrahlung zur Verfügung. Der Ablösevorgang kann auch so gesteuert werden, daß vor dem Ablösen die Qualität der aufgedampften Schichten mit geeigneten Methoden geprüft wird und anschließend die Schichten, die die gewünschten Qualitätsmerkmale zeigen, partiell und/oder in Stufen, z.B. in verschiedenen Ablösekammern, in Abhängigkeit von ihrer Qualität abgelöst werden.

## Patentansprüche

1. Verfahren zur reversiblen Beschichtung von Substraten mit einer Release-Schicht,
**dadurch gekennzeichnet, daß** das Substrat mit einer Release-Schicht aus organischen Monomeren vakuumtechnisch beschichtet wird und die Release-Schicht anschließend vakuumtechnisch abgelöst wird.

2. Verfahren nach Anspruch 1,
**dadurch gekennzeichnet, daß** die Release-Schicht durch thermisches Verdampfen, Kathodenzerstäubung oder CVD aufgedampft wird.

3. Verfahren nach einem der Ansprüche 1 oder 2,
**dadurch gekennzeichnet, daß** die Release-Schicht durch Erhitzen und/oder unter Verwendung von Elektronenstrahlen, Laser, Photonenstrahlung und/oder Infrarotstrahlung abgelöst wird.

4. Verfahren nach einem der Ansprüche 1 bis 3,
**dadurch gekennzeichnet, daß** das Substrat nur teilweise mit der Release-Schicht beschichtet wird.

5. Verfahren nach einem der Ansprüche 1 bis 4,
**dadurch gekennzeichnet, daß** die Release-Schicht in derselben Vakuumkammer aufgetragen und abgelöst wird.

6. Verfahren nach einem der Ansprüche 1 bis 5,
**dadurch gekennzeichnet, daß** vor Ablösen der Release-Schicht auf diese mindestens eine weitere Deckschicht aufgebracht wird.

7. Verfahren nach Anspruch 6,
**dadurch gekennzeichnet, daß** die mindestens eine weitere Deckschicht und die Release-Schicht in derselben Vakuumkanner aufgedampft werden.

8. Verfahren nach einem der Ansprüche 6 oder 7,
**dadurch gekennzeichnet, daß** die Release-Schicht und die mindestens eine weitere Deckschicht in derselben Vakuumkammer aufgedampft und abgelöst werden.

9. Verfahren nach einem der Ansprüche 6 bis 8,
**dadurch gekennzeichnet, daß** die Release-Schicht und die mindestens eine weitere Deckschicht durch thermisches Verdampfen, Kathodenzerstäubung oder CVD aufgedampft werden.

10. Verfahren nach einem der Ansprüche 6 bis 9,
**dadurch gekennzeichnet, daß** vor dem Ablösen der Release-Schicht und der mindestens einen weiteren Deckschicht die Qualität der aufgedampften Schichten mit geeigneten Methoden geprüft wird und anschließend die Schichten, die die gewünschten Qualitätsmerkmale zeigen, partiell - und/oder in Stufen, beispielsweise in verschiedenen Ablösekammern, in Abhängigkeit von ihrer Qualität abgelöst werden.

11. Verfahren nach einem der vorhergehenden Ansprüche,
**dadurch gekennzeichnet, daß** als organische Monomere Triazine oder deren Salze bzw. eine Mischung davon in monomerer Form verwendet werden.

12. Verfahren nach einem der vorhergehenden Ansprüche,
**dadurch gekennzeichnet, daß** als organische Monomere 1,3,5-Triazin oder dessen Salze bzw. eine Mischung davon verwendet werden.

13. Verfahren nach einem der vorhergehenden Ansprüche,
**dadurch gekennzeichnet, daß** als organische Monomere Melamin, Ammelin, Ammelid, Cyanursäure, 2-Ureidomelamin, Melam, Melem, Melon oder Melaminsalze wie Melamincyanurat, Melaminphosphat, Dimelaminpyrophosphat oder Melaminpolyphosphat oder funktionalisiertes Melamin wie Hexamethoxymethyl-Melamin oder acrylatfunktionalisiertes Melamin oder eine Mischung davon verwendet werden.

14. Verfahren nach einem der vorhergehenden Ansprüche,
**dadurch gekennzeichnet, daß** ein Substrat aus flächigen, insbesondere bahnförmigen Materialien wie beispielsweise Polyester, Polypropylen, Polyethylen, Polyamid, Polycarbonat, Papier, Karton, Metallbänder oder deren Kombinationen beschichtet wird.

15. Verfahren nach einem der vorhergehenden Ansprüche,
**dadurch gekennzeichnet, daß** das Substrat vorstrukturiert wird, beispielsweise als geprägte bandförmige Materialien, beispielsweise aus Metallen oder Kunststoffen oder durch Lackierung, beispielsweise UV-härtbare Lackierung.

16. Verfahren nach einem der vorhergehenden Ansprüche, zur Herstellung von Nanopartikeln, zur Herstellung von Pigmenten, beispielsweise metallischen Effektpigmenten, für die Lackierung oder zur Herstellung von Prägefolien.

17. Verfahren nach Anspruch 6,
**dadurch gekennzeichnet, daß** als weitere Deckschichten anorganische Schichten, wie Al-Schichten oder Oxid-Schichten aufgedampft werden.

18. Verfahren nach Anspruch 6,
**dadurch gekennzeichnet, daß** die Release-Schicht anschließend, gegebenenfalls mehrfach, lackiert, beschichtet oder kaschiert wird.

19. Verfahren nache einem der vorhergehenden Ansprüche,
**dadurch gekennzeichnet, daß** das Substrat vor dem Aufdampfen einer der Schichten mit einer Plasmaquelle vorbehandelt wird.
